# EUROPEAN PATENT APPLICATION

(11) **EP 4 465 069 A1**
(43) Date of publication of application: **20.11.2024**
(21) Application number: 23174226.3
(22) Date of filing: 19.05.2023
(51) Int. Cl.: G01R 33/48, G01R 33/483, G01R 33/561, G01R 33/563

(54) **IMPROVED ECHO PLANAR MAGNETIC RESONANCE IMAGING**

(71) Applicant: Siemens Healthineers AG, 91301 Forchheim (DE)
(72) Inventor: Liu, Wei, 91052 Erlangen (DE); Benkert, Thomas, 91077 Neunkirchen am Brand (DE)
(74) Representative: Siemens Healthineers Patent Attorneys

(57) **Abstract**

By using a method according to the invention for recording magnetic resonance (MR) measurement data (MD) of an object (U) under examination by an MR system with an imaging sequence comprises reading out echo signals produced in the object under examination in at least two segments (S1, S2, S3, S4, S5, S1', S2', S3') in a sampled k-space using an echo planar acquisition technique and recording the read out echo signals as measurement data (MD),
wherein echo signals are produced after transmission of at least one RF pulse (22, 23, 24, 25) that excites a magnetization in the object (U) under examination in a predefined field of excitation that is limited in at least two different directions, distortions can be avoided more effectively.

## Description

The invention relates to a method and system for improved echo planar magnetic resonance imaging.

The magnetic resonance technique (the abbreviation MR stands for magnetic resonance below) is a known technique with which images of the interior of an object under examination can be generated. In simplified terms, the object under examination is for this purpose positioned in a magnetic resonance device in a comparatively strong static, homogeneous constant magnetic field, also called a B₀ field, with field strengths of 0.2 tesla to 7 tesla and more, so that its nuclear spins are oriented along the constant magnetic field. To trigger nuclear spin resonances that can be measured as signals, radiofrequency excitation pulses (RF pulses) are irradiated into the object under examination, the triggered nuclear spin resonances are measured as what is known as k-space data and on the basis thereof MR images are constructed, or spectroscopy data is determined. For position encoding of the measurement data, rapidly switched magnetic gradient fields, called gradients for short, are superimposed on the constant magnetic field. A diagram used, which describes a sequence over time of RF pulses to be irradiated and gradients to be switched, is referred to as a pulse sequence (diagram), or else as a sequence for short. The plotted measurement data is digitized and stored as complex numerical values in a k-space matrix. An associated MR image can be reconstructed from the k-space matrix populated with values, for example by means of a multidimensional Fourier transform.

To reduce the duration of a recording of a complete measurement dataset in accordance with the theorem according to Nyquist, it is possible under particular circumstances for particular measurement data in the complete set not to be recorded, but to be added later. Less time is required to record an incomplete measurement dataset than to record a complete measurement dataset. A method such as this is for example a partial Fourier (PF) technique. In PF techniques it is normally not the whole k-space that is sampled, in other words recorded or measured, but, in a k-space direction (PF direction), only a part of the k-space specified by a PF factor and further determined by symmetry considerations of the k-space. The symmetry of the k-space is used in PF techniques to supplement or fill up the unmeasured part of the k-space using various reconstruction methods. For example, in a method referred to as "zero-filling", unrecorded areas of the k-space are filled with zeroes or zero values.

In principle, in order not to extend the repetition times TR in spite of higher resolution or also to accelerate the measurement in general, also so-called parallel acquisition techniques (ppa: "partially parallel acquisition" or PAT: "Parallel Acquisition Technique") can be used, such as, for example, GRAPPA ("GeneRalized Autocalibrating Partially Parallel Acquisition") or SENSE ("Sensitivity Encoding"), in which only an amount of measurement data which is undersampled according to the Nyquist theorem in the k-space is recorded with the aid of a plurality of RF coils. The "missing" measurement data is supplemented in these methods on the basis of sensitivity data of the RF coils used and calibration data from the measured measurement data before the image data is reconstructed. Due to the fact that only some of the measurement data actually required for complete scanning is recorded (typically, for example, only half (= acceleration factor R=2) or a quarter (= acceleration factor R=4), or even only an eighth (= acceleration factor R=8) or less), the readout time required for reading the measurement data is reduced and thus the repetition time can be reduced.

The desire for ever faster MR images in the clinical environment, on the other hand, leads to a renaissance of methods in which a plurality of images is recorded simultaneously. In general, these methods can be characterized in that, at least during a part of the measurement, transverse magnetization of at least two layers is used simultaneously for the imaging process (multi-layer imaging, layer multiplexing, Simultaneous Multi-Slice (SMS)). In contrast, in the case of established "multi-layer imaging", the signal of at least two layers is recorded alternately, in other words, completely independently of one another with a correspondingly longer measurement time.

Known SMS methods are, for example, methods which use methods from the aforementioned imaging by means of ppa, in which knowledge about the sensitivity distribution of the receiver coils used in the acquisition of the measurement data is used as additional information in order to replenish measurement data undersampled in accordance with Nyquist, in the direction of layer selection, in order to separate signals received from a plurality of layers in a superimposed manner into signals of the individual layers. These methods also include, for example, the CAIPIRINHA technique, as described by Breuer et al. in "Controlled Aliasing in Parallel Imaging Results in Higher Acceleration (CAIPIRINHA) for Multi-Slice Imaging", Magnetic Resonance in Medicine 53, 2005, p. 684-691, and the blipped CAIPIRINHA technique, as described by Set-sompop et al. in "Blipped-Controlled Aliasing in Parallel Imaging for Simultaneous Multislice Echo Planar Imaging With Reduced g-Factor Penalty", Magnetic Resonance in Medicine 67, 2012, p. 1210-1224, wherein the g-factor mentioned in the latter title ("g-factor", short for "geometry factor") is a measure of the separability of the various receiver coils used.

In order to improve the signal-to-noise ratio or reduce the sensitivity of movement and/or flow of the measurement in MR measurements, it is already common in many recordings to record measurement data multiple times, in order to be able to undertake averaging of the measurement data or of the reconstructed image data.

In addition, in many examinations it is however also necessary to carry out multiple recordings of measurement datasets, in particular whole series of magnetic resonance recordings of the object under examination, wherein a particular measurement parameter is varied. On the basis of the measurements the effect of this measurement parameter on the object under examination is observed, in order then subsequently to draw diagnostic conclusions therefrom. A series should in this case be understood to mean at least two, but generally more than two, recordings of measurement datasets. A measurement parameter is in this case expediently varied such that the contrast of a particular type of material excited during the measurements, for example of a tissue type of the object under examination or of a chemical substance that is significant for most or particular tissue types, such as water, is influenced as strongly as possible by the variation of the measurement parameter. This ensures that the effect of the measurement parameter on the object under examination is particularly clearly visible.

A typical example of series of magnetic resonance recordings subject to the variation of a measurement parameter are functional magnetic resonance imaging (fMRI) methods, where (neurological) MR images of test subjects or patients are recorded while they are exposed to different stimuli.

Another typical example of series of magnetic resonance recordings subject to the variation of a measurement parameter strongly influencing the contrast are so-called "diffusion weighting imaging" (DWI) methods. Diffusion is understood as the Brownian motion of molecules in a medium. In diffusion imaging, multiple images with different diffusion directions and weightings are generally recorded and are combined with one another. The strength of the diffusion weighting is usually defined by what is known as the "b value". The diffusion images with different diffusion directions and weightings or the images combined therefrom can then be used for diagnostic purposes. Thus, by suitable combinations of the recorded diffusion-weighted images, it is possible to generate parameter maps with particular diagnostic validity, for example maps showing the "Apparent Diffusion Coefficient (ADC)" or the "Fractional Anisotropy (FA)".

In diffusion-weighted imaging additional gradients that reflect a respective diffusion direction, and a respective diffusion weighting are inserted into a pulse sequence, in order to make the diffusion properties of the tissue visible or to measure them. These gradients mean that tissue with a rapid diffusion (e.g. cerebral spinal fluid (CSF)) is subject to a stronger signal loss than tissue with a slow diffusion (e.g. the grey matter in the brain). The resulting diffusion contrast is becoming increasingly clinically meaningful, and applications now extend far beyond the traditional early identification of ischemic stroke.

Diffusion imaging is frequently based on echo planar imaging (EPI), in particular on single-shot EPI (ss-EPI), where all echo signals are recorded as measurement data after one single excitation, because of the short acquisition time of the EPI sequence per image and its robustness with respect to movement.

MR images recorded using EPI methods can suffer from T2*-related blurring and can have local geometric distortions that are caused for example by inhomogeneities in the constant magnetic field. The inhomogeneities can be brought about by susceptibility discontinuities at tissue interfaces, for example in the case of transitions from air to tissue of the object under examination, for example in the case of human or animal patients as an object under examination transitions from bone to softer tissue, and result in local phase accumulations via the readout echo train of the EPI measurement. To minimize the strength of the geometric distortions an attempt can be made to minimize the phase accumulation. To this end the echo train can for example be kept as short as possible, although this restricts the spatial resolution, or parallel imaging techniques can be employed. Further effects, such as (pulsing) movements in the target area of the object under examination, from which measurement data is recorded, can result in (further) phase errors.

To reduce such distortions, two-dimensional (2D) spatially-selective RF excitation pulses (2DRF) have been introduced for ss-EPI to excite only a predefined field of excitation and thus enable the acquisition of small field of views (FOVs) in phase-encoding direction while avoiding infolding artifacts from outside the FOV as described for example in the article of Rieseberg et al. "Two-Dimensional Spatially-Selective RF Excitation Pulses in Echo-Planar Imaging", Magnetic Resonance in Medicine, 47:1186-1193, 2002. Such techniques using a spatially-selective excitation are also called reduced field of view imaging techniques.

In short, this technology is based on a two-dimensional RF pulse, where an echo-planar imaging, EPI, trajectory is used to step through excitation k-space while the required RF energy is applied. One direct consequence of this discretized sampling of excitation k-space are side excitations, which occur along the so-called blip direction of the 2DRF pulse. This blip direction can correspond to the phase-encoding direction of the imaging experiment. Accordingly, infolding artifacts can occur when these side excitations are located in tissue.

To overcome these problems, the excitation EPI trajectory can be rotated, which rotates the site lobes out of the phase-encoding direction as disclosed in Jürgen Finsterbusch: "Improving the Performance of Diffusion-Weighted Inner Field-of-View Echo-Planar Imaging Based on 2D-Selective Radiofrequency Excitations by Tilting the Excitation Plane", Journal of Magnetic Resonance Imaging, 35:984-992, 2012. Here, the side excitations are not refocussed and potential infolding artifacts are effectively overcome. A further improvement of this technique is described in US 11, 486,952 B2.

EPI techniques still suffer from infolding, blurring and distortions, in particular susceptibility induced distortions.

It is an object of the invention to improve the quality of MR measurement data acquired using an EPI technique and in particular to reduce artifacts caused by infolding, susceptibility or T2*-decay.

The object is achieved by a method for recording magnetic resonance (MR) measurement data of an object under examination by an MR system with an imaging sequence as claimed in claim 1, a magnetic resonance system as claimed in claim 11, a computer program as claimed in claim 12, and an electronically readable data carrier as claimed in claim 13.

The invention is based on the finding that it is further possible to record the k-space in segments, that is to perform the recording of measurement data on a segmented basis, and that spatially-selective excitation can be used in conjunction with multi-shot segmented acquisitions. The segmentation of the k-space can in principle take place in the phase encoding direction and/or in the readout direction.

As an example, the so-called RESOLVE technique first described in the article by Porter and Heidemann "High Resolution Diffusion-Weighted Imaging Using Readout-Segmented Echo-Planar Imaging, Parallel Imaging and a Two-Dimensional Navigator-Based Reacquisition", MRM 62, 2009, p.468-475, is a variant of an EPI-type sequence, in which a segmentation takes place in the readout direction instead of in the phase encoding direction. A RESOLVE technique can be combined with diffusion preparation and/or with navigator measurements.

In general terms, in the case of a RESOLVE technique after diffusion preparation by a prephasing gradient the segment of the k-space that is to be filled with measurement data in the subsequent readout phase can be established. In the readout phase a train of echo signals is captured as measurement data for the established segment by means of a sinusoidal readout gradient. By means of a further gradient that has an opposing polarity to that of the prephasing gradient and can be switched following the readout phase, it is possible to return to the k-space centre again in the readout direction, before a further refocusing pulse can be irradiated that results in the formation of further echo signals that are captured as navigator data of the k-space centre by means of a navigator readout gradient. The navigator data thus captured for each segment can be used to correct possible phase changes between the capture of the measurement data in the individual segments, as is described in greater detail in the aforementioned article by Porter and Heidemann.

A method according to the invention for recording magnetic resonance (MR) measurement data of an object under examination by an MR system with an imaging sequence comprises reading out echo signals produced in the object under examination in at least two segments in a sampled k-space using an echo planar acquisition technique and recording the read out echo signals as measurement data, wherein echo signals are produced after transmission of at least one RF pulse that excites a magnetization in the object under examination in a predefined field of excitation that is limited in at least two different directions.

By exciting magnetization only in a predefined field of excitation that is limited in at least two directions, and in particular the resulting limitation of the excited field of excitation in a phase-encoding direction, it is possible to limit the necessary measurement data to be recorded in a phase-encoding direction, thus yielding a higher resolution and/or lesser distortions while avoiding infolding artifacts from outside the limited field of excitation. The predefined field of excitation can be chosen such that a region of interest in the object under examination, for example a particular organ or area of interest, is fitted in the predefined field of excitation to already avoid a creation of MR signals in areas surrounding the region of interest. Through the additional reading out of echo signals in at least two segments, that is not after one single "shot" (one single excitation), but rather in multiple shots, after multiple excitations, the echo spacing and the echo-train duration with which the measurement data can be recorded using an echo planar acquisition technique can be further reduced, resulting in further reduced distortions as well as T2*-related blurring.

A magnetic resonance system according to the invention comprises a magnet unit, a gradient unit, a radio-frequency unit and a control facility designed to carry out a method according to the invention with a distortion reduction unit.

A computer program according to the invention implements a method according to the invention on a control facility when it is executed on the control facility, and comprises electronically readable command information, which carries out the steps of a method according to the invention when it is executed on a computing device, in particular on a control facility of a magnetic resonance system.

The computer program can also be in the form of a computer program product which can be loaded directly into a memory of a control facility, with program code means, in order to carry out a method according to the invention when the computer program product is executed in the computing unit of the computer system.

An electronically readable data carrier according to the invention comprises electronically readable control information stored thereon, which can comprise at least one computer program according to the invention and is designed in such a way that when the data carrier is used in a control facility of a magnetic resonance system, it carries out a method according to the invention.

The advantages and embodiments specified in relation to the method also apply analogously to the magnetic resonance system, the computer program product and the electronically readable data carrier.

Further advantages and details of the present invention will emerge from the exemplary embodiments described hereinafter and with reference to the diagrams. The examples given do not constitute a limitation of the invention. The diagrams show:
Fig. 1 A diagrammatic flow chart of a method according to the invention for recording MR measurement data of an object under examination by an MR system with an imaging sequence,
Figs. 2 and 3 Examples of diagrammatic views of parts of pulse sequence schemes for a spatially selective excitation of a predefined field of excitation that is limited in at least two different directions,
Figs. 4 and 5 Examples of diagrammatic views of possible acquisition schemes of recorded measurement data,
Fig. 6 A diagrammatic view of a magnetic resonance system according to the invention.

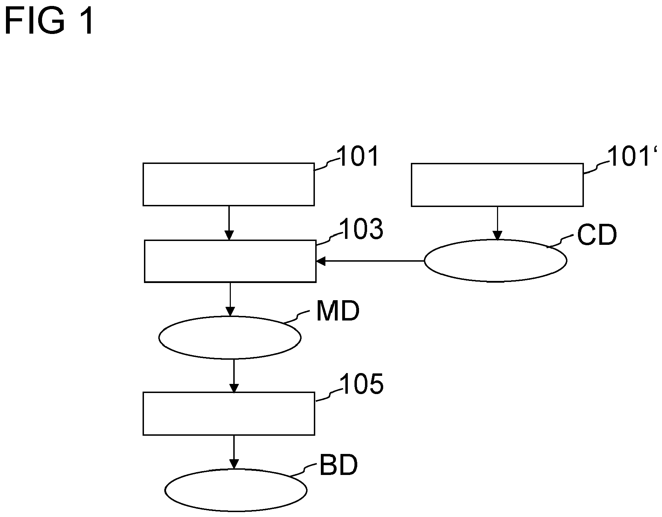

Figure 1 is a diagrammatic flow chart of a method according to the invention for recording MR measurement data MD of an object under examination by an MR system with an imaging sequence.

At least one RF pulse is transmitted into the object of examination that that excites a magnetization in the object under examination in a predefined field of excitation that is limited in at least two different directions (block 101).

In principle, it is possible to achieve a field of excitation that is limited in at least two different directions by transmitting an RF excitation pulse exciting magnetization in a first slice and refocussing the excited magnetization only in a two-dimensionally limited area by transmitting an RF refocussing pulse acting on a second slice which is tilted with regard to the first slice. Such two-dimensionally selective excitation and its advantages are described for (not segmented) ss-EPI in more detail e.g. in the article of Wheeler-Kingshott et al. "ADC Mapping of the Human Optic Nerve: Increased Resolution, Coverage, and Reliability With CSF-Suppressed ZOOM-EPI", Magnetic Resonance in Medicine, 47:24-31, 2002.

At least one of the at least one RF pulses used to excite the magnetization in the predefined field of excitation can be a two-dimensional or three-dimensional spatially selective RF pulse.

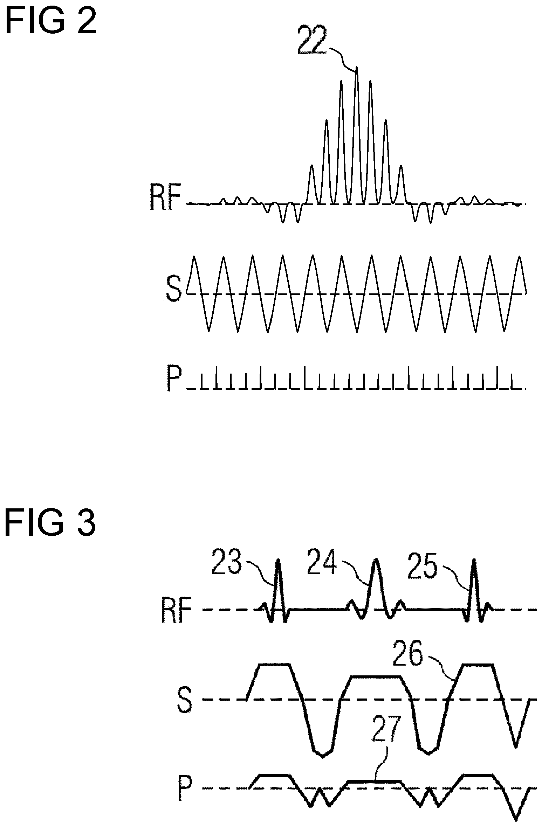

Examples for such spatially selective RF pulses are shown in figures 2 and 3 as diagrammatic views of parts of pulse sequence schemes for a spatially selective excitation of a predefined field of excitation that is limited in at least two different directions

Figure 2 shows in a diagrammatic view the timewise correlation of an RF pulse 22 to be transmitted as well as gradients that can be applied in a slice-selection direction S and a phase-encoding direction P to excite a predefined field of excitation that is limited in at least two directions. By way of example more details on the determination of such RF pulses for spatially selective excitation can be found in the already mentioned article of Rieseberg et al.

At least two two-dimensional spatially selective RF pulses can be used to excite the magnetization in the predefined field of excitation and magnetic field gradients in two different directions. In this way the excitation of the magnetization in the predefined field of excitation. This can be done in a way as described in the already cited article of Finsterbusch.

Figure 3 shows a diagrammatic view of another timewise correlation of (here: three) RF pulses 23, 24, 25 to be transmitted as well as gradients 26 that can be applied in a slice-selection direction S and gradients 27 that can be applied in a phase-encoding direction P to excite a predefined field of excitation that is limited in at least two directions. In this way the predefined field of excitation can also be tilted by a rotation angle alpha with regard to the readout direction. More details regarding the tilting of the field of excitation can be found in the already mentioned article of Finsterbusch as well as in the already mentioned US 11,486,952 B2. Such tilting of the field of excitation helps avoid infolding artifacts.

After the transmission of the at least one RF pulse 22, 23, 24, 25 the echo signals can be produced in a known manner as gradient echo signals, i.e. without transmitting any RF refocussing pulses into the object under examination. Gradient echos can be produced with short echo times and can be recorded in short amounts of measurement time.

Echo signals are produced in the object under examination after the transmission of the at least one RF pulse, and the echo signals produced in the object under examination are read out in at least two segments in a sampled k-space using an echo planar acquisition technique and are recorded as measurement data MD (block 103).

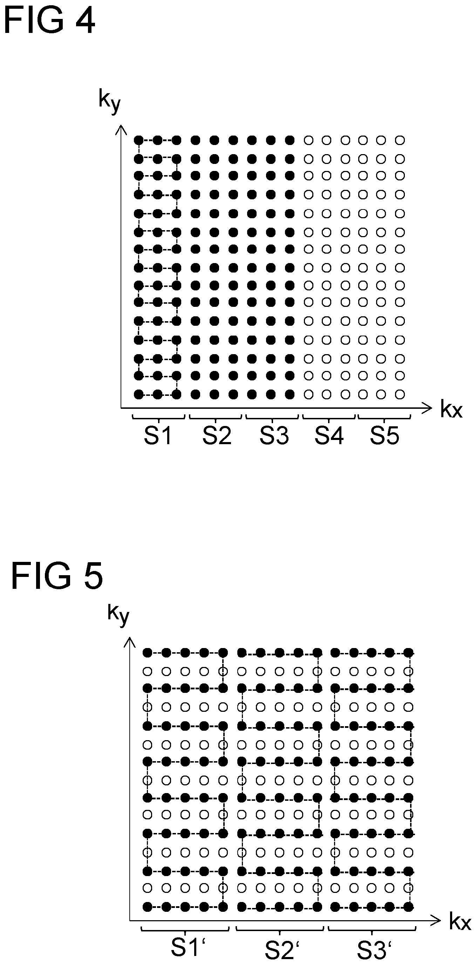

Figure 4 shows an exemplary first diagrammatic view of a possible acquisition scheme of recorded measurement data MD. In this example, the k-space is segmented into five segments S1, S2, S3, S4, S5 in a k-space direction, here corresponding to the readout direction kx, that is measurement data MD of each segment S1, S2, S3, S4, S5 is recorded after transmission of a respective excitation by at least one RF pulse. The example of figure 4 shows a segmentation in a readout direction kx of the sampled k-space, that is the at least two segments S1, S2, S3, S4, S5 segment the sampled k-space in the readout direction kx of the k-space. The segments can be chosen such that they do not overlap in the readout direction kx. It is also possible to have the segments S1, S2, S3, S4, S5 overlap at least a chosen amount in the readout direction kx to facilitate the combination of the measurement data MD of the different segments. By way of such a segmentation in the readout direction kx, the echo train length used while recording the measurement data MD can be further reduced, thus further alleviating distortions and enabling high quality and/or resolutions in image data reconstructed from the recorded measurement data.

In this representation the k-space (points) to be sampled in accordance with Nyquist is in each case represented by circles. Here, filled circles correspond to sampled k-space points, for which measurement data was thus recorded, and circles represented as unfilled correspond to (as of yet in the shown example) unsampled k-space points, and for which measurement data is therefore missing (yet). The segments S4 and S5 can be filled with measurement data after respective further excitations to yield a fully sampled k-space.

If no further measurement data is recorded, only 3/5 of the k-space is recorded, in the shown example which would correspond to a partial Fourier (PF) factor of PF=3/5. The PF direction corresponds to the readout direction kx. In this way, the echo signals recorded as measurement data can be read out using a partial Fourier technique, where not-sampled measurement data that is "missing" in the sense of the Nyquist theorem will be replaced according to the partial Fourier technique used. It is also possible to complete "missing" data in measurement data undersampled according to a partial Fourier technique by using a known trained function, in particular a trained function comprising a neural network.

Figure 5 shows another exemplary diagrammatic view of a possible acquisition scheme of recorded measurement data MD. Same designations are meant to mean the same as in figure 4. In the example of figure 5 the sampled k-space (according to Nyquist) is segmented into three segments S1', S2', S3' by way of example. Here, a parallel acquisition technique is employed in the phase encoding direction ky, such that here only every second k-space line is being sampled. Possible parallel acquisition techniques include GRAPPA and SENSE. As a result of employing such parallel acquisition techniques the speed of recording of the measurement data can be further increased. In this way the echo signals recorded as measurement data can be read out using a parallel acquisition technique and "missing" data according to the Nyquist theorem can be replaced by the used parallel acquisition technique. It is also possible to complete "missing" data in measurement data undersampled according to a parallel acquisition technique by using a known trained function, in particular a trained function comprising a neural network. Calibration data CD for use in conjunction with parallel acquisition techniques to complement missing (not-sampled) data can be recorded in a separate measurement (block 101') or with the recording of the measurement data MD.

It is further conceivable to combine the use of a parallel acquisition technique and of a partial Fourier technique. In the example given in figure 5, this could be achieved by not sampling segment S1' or segment S3'. Any kind of undersampling technique reduces the amount of measurement data that has to be recorded and thus the amount of measurement time necessary, it can also help to shorten echo times and/or echo train durations of echo planar acquisitions which in turn helps to reduce distortions.

In each case, the measurement MD is recorded using an echo planar acquisition technique with changing readout directions as indicated in segment S1 of figure 4 and in segments S1', S2', S3' of figure 5 by the dashed k-space trajectory along which the measurement data MD of the respective segment can be recorded.

In particular, the measurement data MS can be recorded by using a RESOLVE technique. When using a RESOLVE technique, the relaxation method (T2/T2* decay), on which the measurement data recorded in the various segments is based, is in each case identical for all segments. Hence RESOLVE techniques are particularly well suited for use in conjunction with PF techniques based on symmetry overlays, in particular in comparison to other recording techniques less symmetrical in the PF direction, such as for example EPI without segmentation in the readout direction. When combining a RESOLVE technique with a PF technique, it is directly possible to save measurement time, since thanks to the PF technique fewer segments are recorded (with the same repeat time TR for each segment). When combining EPI techniques without segmentation in readout direction with PF techniques, measurement time is generally not saved during the actual recording of the measurement data, since then, the repeat time TR is not shortened (since it also influences the contrast of a resulting image dataset).

However, for this a reduction in echo times TE and/or a reduction in blurring artifacts can be achieved, since the EPI echo train can be shortened thanks to the PF technique. Additionally or alternatively, a PF technique could also be applied in the phase-encoding direction to again shorten the necessary echo train length and/or the echo times.

From the recorded measurement data MD image data BD can be reconstructed and stored (block 105).

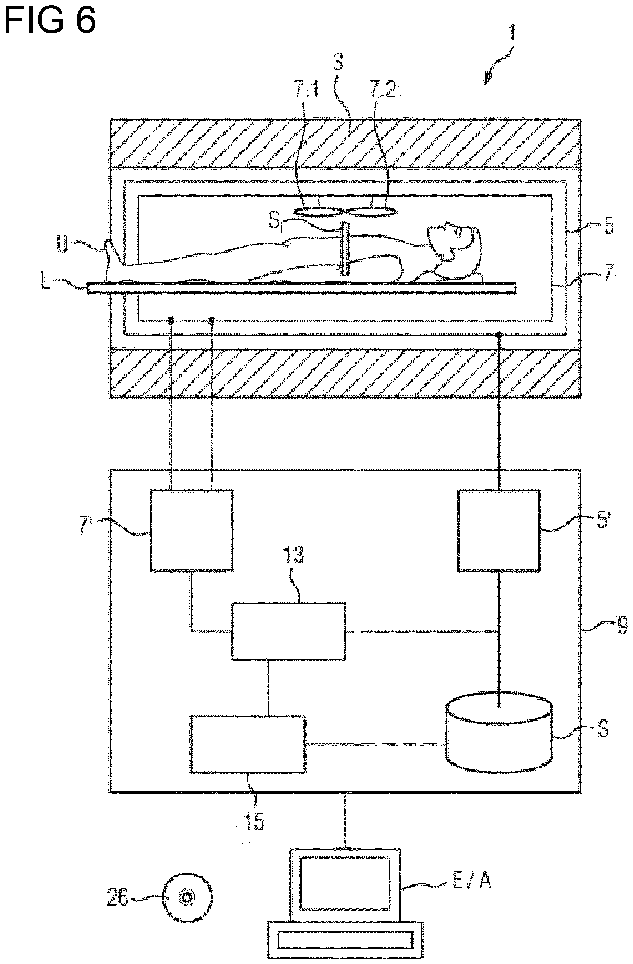

Figure 6 shows a diagrammatic view of a magnetic resonance system 1 according to the invention. This comprises a magnet unit 3 for generating the basic magnetic field, a gradient unit 5 for generating the gradient fields, a radio-frequency unit 7 for irradiation and for receiving radio-frequency signals and a control facility 9 designed to carry out a method according to the invention.

Figure 6 provides only a rough diagrammatic view of these partial units of the magnetic resonance system 1. In particular, the radio-frequency unit 7 may consist of a plurality of subunits, for example of a plurality of coils such as the coils 7.1 and 7.2 shown in a diagrammatic view or more coils which may be designed either only for transmitting radio-frequency signals or only for receiving the triggered radio-frequency signals or for both.

For the examination of an object to be examined U, for example a patient or also a phantom, this can be introduced into the measurement volume of the magnetic resonance system 1 on a bed L. The layer or the slab Sᵢ represents an exemplary target volume or, for example in the case of using a layer-multiplexing method, a part of a target volume consisting of different layers of the object to be examined from which echo signals are to be recorded and included as measurement data.

The control facility 9 serves to control the magnetic resonance system 1 and can, in particular, control the gradient unit 5 by means of a gradient controller 5' and the radio-frequency unit 7 by means of a radio-frequency transceiver controller 7'. The radio-frequency unit 7 may comprise a plurality of channels on which signals can be transmitted or received.

The radio-frequency unit 7, together with its radio-frequency transceiver controller 7', is responsible for generating and irradiating (transmitting) a radio-frequency alternating field for manipulating the spins in a region to be manipulated (for example, in layers S to be measured) of the object to be examined U. In this case, the center frequency of the radio-frequency alternating field, also referred to as the B1 field, is generally set as far as possible in such a way that it is close to the resonance frequency of the spins to be manipulated. Deviations from the center frequency by the resonance frequency are referred to as off-resonance. In order to generate the B1 field, controlled currents are applied to the RF coils in the radio-frequency unit 7 by means of the radio-frequency transceiver controller 7'.

Furthermore, the control facility 9 comprises a distortion reduction unit 15 with which controls the transmitted RF pulse for excitation of the predefined field of excitation and the segmentation used for sampling measurement data in k-space according to the invention. The control facility 9 as a whole is designed to carry out a method according to the invention.

A computing unit 13 comprised by the control facility 9 is designed to perform all the computing operations necessary for the necessary measurements and determinations. Intermediate results and results required for this or determined in the process can be stored in a storage unit S of the control facility 9. The units shown here are not necessarily to be understood as physically separate units, but merely represent a subdivision into sense units which, however, can also be realized for example, in fewer or even in only one physical unit.

Via an input/output facility I/O of the magnetic resonance system 1, for example, control commands can be sent by a user to the magnetic resonance system and/or results of the control facility 9, such as for example, image data, can be displayed.

A method described herein can also be in the form of a computer program product which comprises a program and implements the method described on a control facility 9 when it is executed on the control facility 9. Likewise, an electronically readable data carrier 26 with electronically readable control information stored thereon can be present, which comprises at least one such computer program product as described and is designed in such a way that it carries out the method described when the data carrier 26 is used in a control facility 9 of a magnetic resonance system 1.

Independent of the grammatical term usage, individuals with male, female or other gender identities are included within the term.

## Claims

1. A method for recording magnetic resonance (MR) measurement data (MD) of an object (U) under examination by an MR system with an imaging sequence comprising:
reading out echo signals produced in the object under examination (U) in at least two segments (S1, S2, S3, S4, S5, S1', S2', S3') in a sampled k-space using an echo planar acquisition technique and recording the read out echo signals as measurement data (MD),
wherein echo signals are produced after transmission of at least one RF pulse (22, 23, 24, 25) that excites a magnetization in the object under examination (U) in a predefined field of excitation that is limited in at least two different directions.

2. The method as claimed in claim 1, wherein the at least two segments (S1, S2, S3, S4, S5, S1', S2', S3') segment the k-space in a readout direction (kx).

3. The method as claimed in one of the preceding claims, wherein at least one of the at least one RF pulses (22, 23, 24, 25) used to excite the magnetization in the predefined field of excitation is a two-dimensional or three-dimensional spatially selective RF pulse.

4. The method as claimed in one of the preceding claims, wherein at least two two-dimensional spatially selective RF pulses (23, 24, 25) are used to excite the magnetization in the predefined field of excitation and magnetic field gradients (26, 27) in two different directions are applied during the transmission of at least one of the used two-dimensional spatially selective RF pulses (23, 24, 25).

5. The method as claimed in one of the preceding claims, wherein the predefined field of excitation is tilted by a rotation angle alpha with regard to the readout direction (kx).

6. The method as claimed in one of the preceding claims, wherein the echo signals are read out using a RESOLVE technique.

7. The method as claimed in one of the preceding claims, wherein the echo signals produced are gradient echo signals.

8. The method as claimed in one of the preceding claims, wherein the echo signals are read out only in an undersampled manner in k-space according to the Nyquist theorem.

9. The method as claimed in claim 8, wherein the echo signals are read out using a parallel acquisition technique and/or a partial Fourier technique.

10. The method as claimed in one of the claims 8 or 9, wherein missing data of echo signals read out in an undersampled manner are completed by using a trained function, in particular a trained function comprising a neural network.

11. A magnetic resonance system (1) comprising a magnet unit (3), a gradient unit (5), a radiofrequency unit (7) and a control facility (9) with a radiofrequency transceiver controller (7') and having a distortion reduction unit (15), wherein the control facility (9) is designed to execute a method as claimed in one of claims 1 to 10 on the magnetic resonance system (1).

12. A computer program, comprising electronically readable command information, which carries out the steps of a method as claimed in one of claims 1 to 10 when it is executed on a computing device, in particular in a control facility (9) of a magnetic resonance system (1).

13. An electronically readable data carrier comprising electronically readable control information stored thereon designed in such a way that when the data carrier is used in a control facility (9) of a magnetic resonance system (1), it carries out the method as claimed in one of the claims 1 to 10.
